# EUROPEAN PATENT APPLICATION

(11) **EP 4 502 854 A1**
(43) Date of publication of application: **05.02.2025**
(21) Application number: 23188989.0
(22) Date of filing: 01.08.2023
(51) Int. Cl.: G06F 30/20, H04L 67/12, H04W 4/70

(54) **SYSTEM AND METHOD FOR OPTIMIZING OPERATIONAL PARAMETERS OF ASSETS IN AN INTERNET-OF-THINGS ENVIRONMENT**

(71) Applicant: Siemens Aktiengesellschaft, 80333 München (DE)
(72) Inventor: CHANDRATREY, Abhinav, 411045 Pune, Maharashtra (IN); GUPTA, Hitesh, 411057 Pune, Maharashtra (IN); REDDY, Madhu, Troy, 48084 (US); D'LPPOLITO, Roberto, 3001 Heverlee (BE)
(74) Representative: Isarpatent

(57) **Abstract**

A system (100) and method for optimizing operational parameters of assets in an Internet-Of-Things (IoT) environment is disclosed. The method comprises receiving IoT data indicative of an event in an IoT environment, from a source. Further a digital twin, of at least one asset (108) in the IoT environment, is configured based on the received loT data. Further, a data package is generated based on the configured digital twin of the asset (108) by invoking a connector script. The generated data package is transmitted to the client (114), wherein the client (114) analyses a behavior of the asset (108) based on the data package to compute one or more optimized operational parameters for the asset (108).

## Description

The present invention relates to managing performance of industrial assets, and more particularly relates to a system and method for optimizing operational parameters of assets in an Internet-Of-Things environment.

Operational parameters of assets need to be fine-tuned based on an environment the asset operates in. Conventionally, such fine-tuning requires domain expertise. For example, a power drive may be designed to work on a line voltage of 420 V. However, the voltage and current may fluctuate during operation of the power drive owing to several reasons. In such a case, it is necessary to determine how the drive would behave if the voltage fluctuated, for enabling effective optimization of the respective operational parameters. In general, it is necessary to optimize performance of an asset such that longevity of the asset is not compromised, even if an operational environment or operating condition of the asset changes.

In existing art, fine-tuning operational parameters of assets requires manual intervention. In other words, a human expert has to manually tune the operational parameters each time the operational environment and/or operating condition of the asset changes.

In light of the above, there exists a need for a system and method that enables auto-tuning or optimizing of operational parameters of assets in an Internet-of-Things environment.

Disclosed herein is a system and method for optimizing operational parameters of assets in an Internet-of-Things (IoT) environment.

According to a first aspect of the present invention, a method for optimizing operational parameters of assets in an IoT environment is disclosed. The method includes receiving IoT data indicative of an event in an IoT environment, from a source. In an embodiment, the event is a change in at least one of an operating condition of the asset and an operating environment of the asset, detected by the source in real-time. The method further includes configuring a digital twin, of at least one asset in the IoT environment, based on the received IoT data.

The method further includes generating a data package based on the configured digital twin of the asset by invoking a connector script. In an embodiment, generating the data package based on the configured digital twin of the asset includes provisioning digital twin data to be provided to the client using the connector script; and generating the data package based on the provisioned digital twin data.

The method further includes transmitting the generated data package to the client, wherein the client analyses a behavior of the asset based on the data package to compute one or more optimized operational parameters for the asset. In an embodiment, analyzing the behavior of the asset based on the data package, by the client, includes, configuring an asset simulation model for the asset based on the data package; generating one or more asset simulation instances based on the configured asset simulation model; executing the one or more asset simulation instances in a simulation environment, to generate one or more simulated responses; and using an optimization algorithm to compute one or more optimized operational parameters for the asset based on analysis of the one or more simulated responses.

In an embodiment, the method further includes, obtaining the one or more optimized operational parameters from the client; and providing the optimized operational parameters to a target device in the IoT environment. In a further embodiment, the target device is configured to control an operation of the asset based on the one or more optimized operational parameters. In another embodiment, the method further includes configuring a user interface associated with the target device based on the one or more optimized operational parameters.

According to a second aspect of the present invention, a system for optimizing operational parameters of assets in an IoT environment is disclosed. The system includes at least one source configured to provide IoT data indicative of an event in an IoT environment, at least one client, and a cloud computing system communicatively coupled to the at least one source and the at least one client.

The cloud computing system is configured for receiving the IoT data indicative of the event in the IoT environment from the source. In an embodiment, the event is a change in at least one of an operating condition of the asset and an operating environment of the asset, detected by the source in real-time. In another embodiment, the source is associated with at least one of a sensor, an actuator, an industrial control system and an edge device within the IoT environment.

The system is further configured for configuring a digital twin, of at least one asset in the IoT environment, based on the received IoT data.

The cloud computing system is further configured for generating a data package based on the configured digital twin of the asset by invoking a connector script. In an embodiment, the cloud computing system generates the data package based on the configured digital twin of the asset by, provisioning digital twin data to be provided to the client using the connector script; and generating the data package based on the provisioned digital twin data.

The cloud computing system is further configured for transmitting the generated data package to the client, wherein the client is configured to analyze a behavior of the asset based on the data package, to compute one or more optimized operational parameters for the asset. In an embodiment, the client is configured for analyzing the behavior of the asset based on the data package by, configuring an asset simulation model for the asset, based on the data package; generating one or more asset simulation instances based on the configured asset simulation model; executing the one or more asset simulation instances in a simulation environment, to generate one or more simulated responses of the asset; and using an optimization algorithm to compute one or more optimized operational parameters for the asset based on analysis of the one or more simulated responses.

In an embodiment, the cloud computing system is further configured for obtaining the one or more optimized operational parameters from the client; and providing the optimized operational parameters to a target device in the IoT environment. In a further embodiment, the target device is configured for controlling an operation of the asset based on the one or more optimized operational parameters.

According to a third aspect of the present invention, a cloud computing system is disclosed. The cloud computing system is configured for receiving IoT data indicative of an event in an IoT environment from a source; configuring a digital twin, of at least one asset in the IoT environment, based on the received IoT data; generating a data package based on the configured digital twin of the asset by invoking a connector script; and transmitting the generated data package to a client, wherein the client analyzes a behavior of the asset based on the data package to compute one or more optimized operational parameters for the asset.

The above-mentioned attributes, features, and advantages of the present invention and the manner of achieving them, will become more apparent and understandable (clear) with the following description of embodiments of the invention in conjunction with the corresponding drawings. The illustrated embodiments are intended to illustrate, but not limit the invention.

The present invention is further described hereinafter with reference to illustrated embodiments shown in the accompanying drawings, in which:
- FIG 1: shows a schematic representation of a system for enabling optimization of operational parameters associated with assets in an Internet-of-Things (IoT) environment, according to an embodiment of the present invention;
- FIG 2: shows a schematic representation of a client, according to one embodiment of the present invention;
- FIG 3: shows a block diagram of a closed loop simulation module, according to one embodiment of the present invention;
- FIG 4: shows a block diagram of a digital twin management module, according to one embodiment of the present invention; and
- FIG 5: shows a flowchart of a method for optimizing operational parameters of the at least one asset 108 within the IoT environment.

Hereinafter, embodiments for carrying out the present invention are described in detail. The various embodiments are described with reference to the drawings, wherein like reference numerals are used to refer to like elements throughout. In the following description, for purpose of explanation, numerous specific details are set forth in order to provide a thorough understanding of one or more embodiments. It may be evident that such embodiments may be practiced without these specific details.

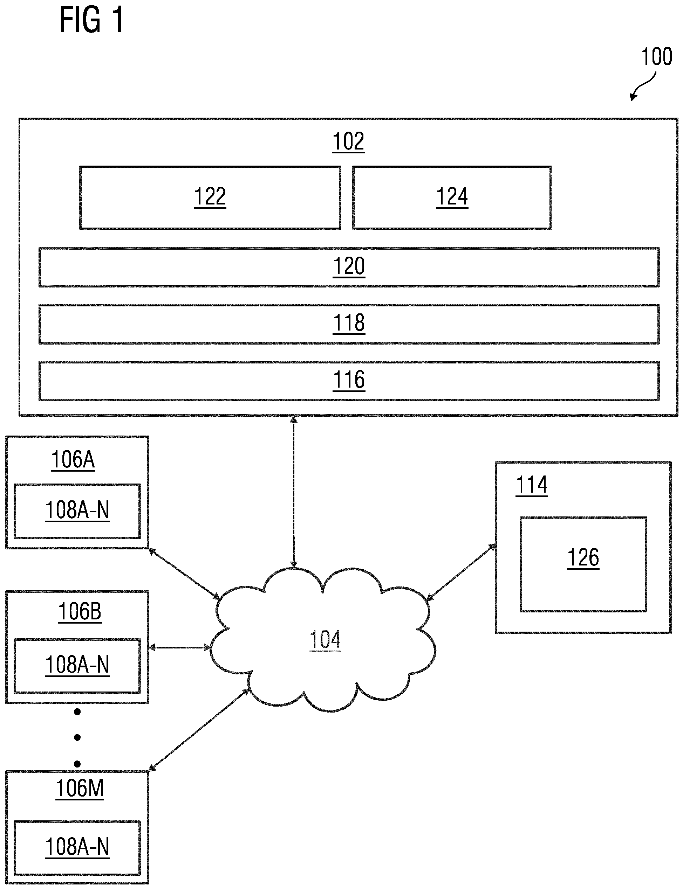

FIG 1 shows a schematic representation of a system 100 for enabling optimization of operational parameters associated with assets in an Internet-of-Things (IoT) environment, according to an embodiment of the present invention. The term 'operational parameter' as used herein refers to at least one controllable variable associated with an asset, that may be brought to a desired optimum value (optimized operational parameter) using a suitable control mechanisms. Non-limiting examples of operational parameters include pressure, temperature, voltage, load etc. The system 100 includes a cloud computing system 102 which is capable of providing cloud services for managing technical installations/industrial plants 106A-M associated with one or more tenants of the cloud computing system 102. In the present example, the industrial plant 106A comprises assets 108A-N, the industrial plant 106B comprises assets 110A-N and the industrial plant 106M comprises assets 112A-N. Each of the assets 108A-N, 110A-N and 112A-N perform one or more production processes. The cloud computing system 102 is connected to assets 108A-N, assets 110A-N, assets 112A-N in the industrial plants 106A-M via a network 104, to form the IoT environment. In addition, the IoT environment may also include sensors, actuators, edge devices, controllers, industrial control systems and the like, that are necessary for effective operation of the assets 108A-N, assets 110A-N and assets 112A-N. The network 104 may include for example, internet, cellular networks, satellite networks, Wi-Fi, Bluetooth, RFID, NFC, LPWAN, and Ethernet or a combination thereof. The cloud computing system 102 is further communicatively coupled to one or more clients 114. The term 'client' as used herein refers to a hardware or software that accesses the cloud services to perform one or more functions based on data provided by at least one of the cloud services. Hereinafter, the one or more clients 114 are collectively referred to as the client 114. Each client 114 may be associated with the tenants or subtenants of the cloud computing system 102. In the present embodiment, the client 114 hosts a computer-aided engineering software such as, for example, HEEDS (a product from Siemens AG).

The assets 108A-N, 110A-N, and 112A-N may hereinafter also be referred to as the asset 108 or the at least one asset 108, and the industrial plants 106A-M may hereinafter be referred as the industrial plant 106 or the at least one industrial plant 106 for ease of explanation. Non-limiting examples of the at least one asset 108 include any machinery or equipment such as servers, robots, switches, motors, valves, pumps, actuators, sensors, gear, gear-drives, bearing, shaft, switchgear, rotor, circuit breaker, protection devices, remote terminal units, transformers, reactors, disconnectors, gradient coils, magnet, radio frequency coils, automation devices (such as Programmable Logic Control (PLC) systems), Computerized Numerical Control based systems (such as Sinumerik), turbines, large drives, medical equipment etc. The asset 108 may be part of a complex industrial plant 106 comprising a plurality of assets such as a power plant, wind farm, power grid, manufacturing facility, process plants and so on. The operation of the assets 108 may be affected by changes in operational environment or operational conditions. For example, changes in operational environment may include changes in an ambient environment of the asset 108, for example, due to rise or fall of ambient temperature, presence of moisture, ambient vibrations etc. Similarly, changes in operational conditions may include changes in parameters such as supply voltage to the asset 108, supply pressure, flowrate of an inlet fluid etc.

According to the present invention, the cloud services may include receiving IoT data from at least one source communicatively coupled to the cloud computing platform 120, configuring a digital twin of the at least one asset 108 based on the received IoT data, generating data packages based on the configured digital twin, enabling execution of the data packages on the client 114, subsequently obtaining one or more optimal control parameters for the asset 108 from the client 114, and providing the optimized operating parameters to a target device in the IoT environment.

The at least one source from which the IoT data is received is associated with at least one of a sensor, an actuator, an industrial control system and an edge device within the IoT environment. Non-limiting examples of such sources may include sensing units, controllers or industrial control systems, edge devices, workstations, etc. that are configured to supply IoT data associated with the at least one asset 108 associated with the at least one industrial plant 106 to the cloud computing system 102 via the network 104. The term `IoT data' as used herein may include, but is not limited to, sensor data, operational statuses, controller setting parameters, load, inputs and outputs associated with the asset 108.

In general, a digital twin is a virtual representation of the asset 108 that is representative of a state of the asset 108 at a specific instance of time. In one implementation, the digital twin of the asset 108 may be generated based on one or more of Computer-Aided Design (CAD) models, Computer-Aided Engineering (CAE) models, one-dimensional (1D) models, two-dimensional (2D) models, three-dimensional (3D) models, finite-element (FE) models, descriptive models, metamodels, stochastic models, parametric models, reduced-order models, statistical models, heuristic models, prediction models, ageing models, machine learning models, Artificial Intelligence models, deep learning models, system models, and so on.

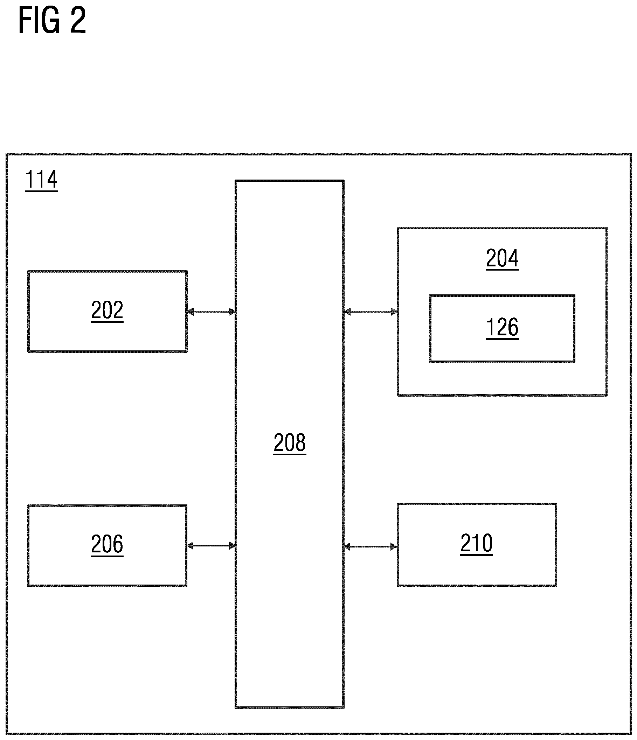

In the present disclosure, the cloud service enables optimizing operational parameters of the asset 108 or industrial plant 106A-M based on changes in operating conditions or operating environment as explained with reference to FIGS 2 to 5 below.

The cloud computing system 102 comprises a cloud interface 116, cloud hardware and Operating System (OS) 118, a cloud computing platform 120, a digital twin management module 122, and a database 124. The cloud interface 116 enables communication between the cloud computing platform 120 and the industrial plants 106A-M. Also, the cloud interface 116 enables communication between the cloud computing platform 120, the client 114 and the target device.

The cloud hardware and OS 118 may include one or more servers on which an operating system is installed and comprising one or more processors, one or more storage devices for storing data, and other peripherals required for providing cloud computing functionality. The cloud computing platform 120 is a platform which implements functionalities such as data storage, data analysis, data visualization, data communication on the cloud hardware and OS 118 via Application Programming Interfaces and algorithms and delivers the aforementioned cloud services to the one or more tenants. The cloud computing platform 120 may comprise a combination of dedicated hardware and software built on top of the cloud hardware and OS 118.

The digital twin management module 122 is stored in the form of machine-readable instructions and executable by the cloud computing platform 120. The digital twin management module 122 is configured to manage digital twins of the at least one asset 108 throughout the lifecycle of the at least one asset 108. The digital twin management module 122 when executed causes the cloud computing system 102 to perform functions such as, receiving the IoT data indicative of an event in the IoT environment from a source, configuring a digital twin of at least one asset 108 based on the received IoT data, generating a data package based on the configured digital twin of the asset 108 by invoking a connector script, and transmitting the generated data package to the client 114. The client 114 is configured to analyze a behavior of the asset 108 based on the data package, to compute one or more optimized operational parameters for the asset 108. The digital twin management module 122 may be further configured for obtaining the one or more optimized operational parameters from the client 114, and for providing the optimized operational parameters to a target device in the IoT environment. In an embodiment, the client 114 and the target device may be software programs on a single hardware device. Non-limiting examples of such hardware devices may include, a desktop computer, a laptop computer, tablet, smartphone and the like. The functionalities of the client 114 is explained in detail below, with reference to FIG 2.

FIG 2 shows a schematic representation of the client 114, according to one embodiment of the present invention. The client 114 includes one or more processors 202, a memory unit 204, a storage unit 206, a communication interface 208, a cloud adapter 210.

The one or more processors 202 execute machine-readable instructions stored on a computer-readable storage medium such as the memory unit 204 for performing closed loop simulation locally in real-time based on the data package received from the cloud computing system 102. Herein, the term 'closed loop simulation' as used herein may be defined as simulations based on real-time or near real-time IoT data (i.e., the data package).

The memory unit 204 includes a closed loop simulation module 126 stored in the form of machine-readable instructions and executable by the processor 202. The closed loop simulation module 126 is configured to analyze the behavior of the asset 108 based on the data package to compute one or more optimized operational parameters for the asset 108.

The closed loop simulation module 126 when executed performs functions such as, but not limited to, configuring an asset simulation model for the asset 108 based on the data package, generating one or more asset simulation instances based on the configured asset simulation model, executing the one or more asset simulation instances in a simulation environment to generate one or more simulated responses, and using an optimization algorithm to compute the one or more optimized operational parameters for the asset 108 based on analysis of the one or more simulated responses. The term 'asset simulation instance' as used herein refers to a simulation executed in an instance or thread associated with the asset simulation model that is independent of all other instances or threads in execution.

The storage unit 206 may be volatile or non-volatile storage. In the preferred embodiment, the storage unit 206 stores simulation models, simulation instances, default simulation parameter values associated with the asset 108 and simulated responses. The communication interface 208 acts as interconnect means between different components of the client 114. The communication interface 208 may enable communication between the processor 202, the memory unit 204 and the storage unit 206.

The cloud adapter 210 is configured to establish and maintain communication links with the cloud computing system 102. The client 114 may also include an input unit such as a keyboard, mouse, touchscreen display and an output unit such as a graphical user interface which enables to user of the client 114, i.e., a tenant or a sub-tenant, to perform closed loop simulation locally on the client 114 in real-time. For example, the tenant may be an original equipment manufacturer of the asset 108, whereas the subtenant may be user of the asset 108.

Those of ordinary skilled in the art will appreciate that the hardware depicted in FIG 2 may vary for specific implementations. For example, other peripheral devices such as an optical disk drive and the like, Local Area Network (LAN)/ Wide Area Network (WAN)/ Wireless (e.g., Wi-Fi) adapter, graphics adapter, disk controller, input/output (I/O) adapter also may be used in addition or in place of the hardware depicted. The depicted example is provided for the purpose of explanation only and is not meant to imply architectural limitations with respect to the present disclosure.

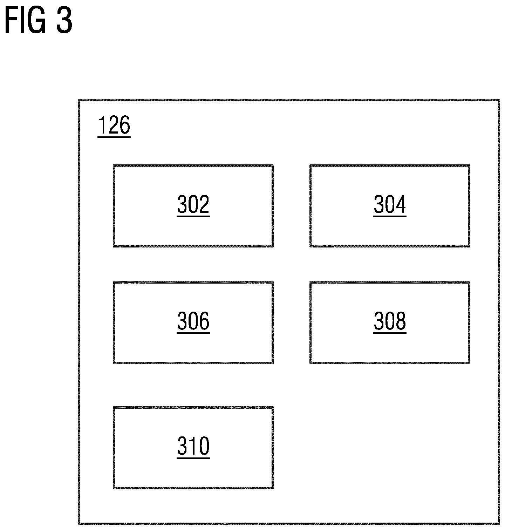

FIG 3 shows a block diagram of the closed loop simulation module 126, according to one embodiment of the present invention. Particularly, the closed loop simulation module 126 includes a simulation model generation module 302, a simulation instance creation module 304, a simulation instance execution module 306, and an optimization module 308.

The simulation model generation module 302 is configured to generate an asset simulation model of the asset 108. The asset simulation model is capable of simulating or modelling behavior of the asset 108 in a simulation environment. Non-limiting examples of an asset simulation model may comprise Computer-Aided Design (CAD) models, Computer-Aided Engineering (CAE) models, one-dimensional (1D) models, two-dimensional (2D) models, three-dimensional (3D) models, FE models, descriptive models, metamodels, stochastic models, parametric models, reduced-order models, statistical models, heuristic models, prediction models, ageing models, machine learning models, Artificial Intelligence models, deep learning models, system models, and knowledge graphs.

In one embodiment, the simulation model generation module 302 is adapted to select at least one simulation model stored in the storage unit 206. In an example, the similar asset simulation models may be identified from among a plurality of asset simulation models, stored in the storage unit 206, based on a type of the asset 108 for which the asset simulation model is to be configured. In another embodiment, the simulation model generation module 302 is configured to generate the asset simulation model using simulation data imported from other tools such as computer-aided design tools, finite element analysis tools, and computational fluid dynamics tools on the client 114, using Application Programming Interfaces (APIs).

The simulation instance creation module 304 is configured to generate one or more asset simulation instances based on the configured asset simulation model. In an embodiment, each of the asset simulation instances are generated based on design points present in a Design of Experiments generated using a predefined design space exploration technique, based on the IoT data. In an implementation, the IoT data over a specific interval may be indicative of types and approximate ranges of operational parameters associated with the asset 108. The design space exploration technique may generate the design space based on the types and ranges of the operational parameters inferred from the IoT data. Further, the design space is sampled, using a predefined sampling technique, to generate the design points. Each of the design points correspond to a unique combination of values of two or more of the operational parameters. For example, if the IoT data indicates two operational parameters 'x' and 'y' of ranges '0-10' and '2 to 2.5' respectively, sampled design points may include (x=1, y= 2.2), (x=4, y=2.4) etc. Further, each such design points is used to generate an asset simulation instance. It must be understood that the one or more asset simulation instances may be generated for serial execution, parallel execution or a combination thereof.

The simulation instance execution module 306 is configured to execute the one or more asset simulation instances in a simulation environment on the client 114, to generate one or more simulated responses of the asset 108. In an embodiment, The simulated responses may include a performance metric of the asset 108. The performance metric is indicative of the behavior of the asset 108 corresponding to the specific combination of operational parameters in the design point. The simulation environment may be provided by a client-based or web-based application that provide an Integrated Development Environment (IDE) for enabling execution of simulations on the client 114. In particular, execution of the asset simulation instance results in simulation of behavior of the asset 108 in real-time. Further, the one or more asset simulation instances may be executed in the simulation environment in the form of stochastic simulations, deterministic simulations, dynamic simulations, continuous simulations, discrete-event simulations, local simulations, distributed simulations and so on.

The optimization module 308 is configured to compute one or more optimized operational parameters for the asset 108 based on analysis of the one or more simulated responses, using an optimization algorithm. In a preferred embodiment, the optimization is performed using a SHERPA optimization strategy. SHERPA is an auto-tuning optimization strategy based on one or more optimization algorithms. Other optimization algorithms based on, for example, genetic algorithm, neural network algorithm, Artificial intelligence-based algorithm, fuzzy-logic based algorithms etc., may also be used. In an embodiment, aspects such as objectives, constraints and variables to be used for the optimization may be defined by a user on the client 114 in real-time. In another embodiment, the aspects may be predefined and stored in a memory of the client 114.

In an embodiment, the one or more optimized operational parameters are further ingested/ transmitted to the cloud computing system 102. In an embodiment, the closed loop simulation module 126 may include a notification module 310 configured for generating a notification indicating at least one of the simulated responses, and the one or more optimized operational parameters.

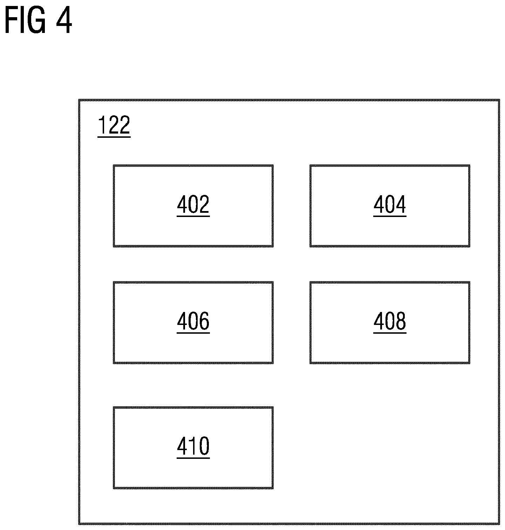

FIG 4 shows a block diagram of a digital twin management module 122, in accordance with an embodiment of the present invention. In the present embodiment, the digital twin management module 122 further comprises an IoT data processing module 402, a digital twin configuration module 404, a data packaging module 406, a control module 408 and a visualization module 410.

The IoT data processing module 402 is configured to receive IoT data indicative of an event in the IoT environment from the source. The IoT data processing module 402 may also preprocess the IoT data in raw format from the at least one source into a format suitable for further processing by the digital twin configuration module 404.

The digital twin configuration module 404 further configures a digital twin corresponding to the asset 108 the received IoT data. The data packaging module 406 is configured to generate a data package based on the configured digital twin by invoking a connector script. The data packaging module 406 is further configured to transmit the data package to the client 114. The client 114 further analyses a behavior of the asset 108 based on the data package to compute one or more optimized operational parameters for the asset 108. The control module 408 is configured obtain the one or more optimized operational parameters from the client 114 and provide the optimized operational parameters to a target device in the IoT environment. The target device is, for example, a controller or an edge device. The visualization module 410 is configured to render a visual representation indicating the one or more optimized operational parameters on a user interface of a target device.

The client 114 is configured to access the cloud computing system 102 and to perform closed loop simulations locally using simulation models configured based on the data package received from the cloud computing system 102 in real-time, to generate the simulated responses as explained earlier with reference to FIGS 2 and 3. Herein, the term 'access' may refer to being able to receive data package corresponding to digital twin of at least one asset 108 and to transmit simulated responses and/or the optimized operational parameters.

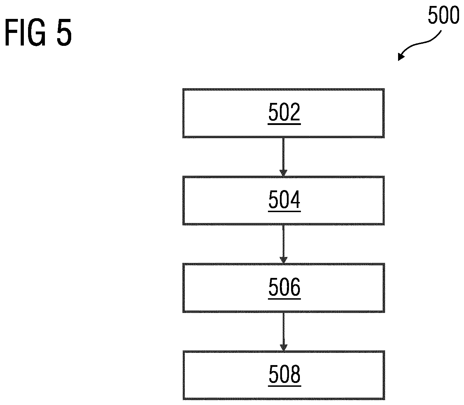

FIG 5 shows a flowchart of a method 500 for optimizing operational parameters of the at least one asset 108 within the IoT environment, according to an embodiment of the present invention. The method 500 is explained below in detail with reference to FIGS 1 to 4. The method 500 is executable on the cloud computing system 102 described earlier.

At step 502, IoT data indicative of an event in the IoT environment is received from a source. In an embodiment, the event is a change in at least one of an operating condition of the asset 108 and an operating environment of the asset 108, detected by the source in real-time. In an embodiment, the source is associated with at least one of a sensor, an actuator, an industrial control system and an edge device within the IoT environment. In an implementation, the source is a device (e.g., a workstation) configured to detect the event based on real-time input from at least one of a sensor, an actuator, an industrial control system and an edge device. In an example, the source may be an edge device that has detected increase in ambient temperature above a predefined value. The IoT data is further converted into a format that is more suited for further processing. For example, the preprocessing may involve data conversion from a protocol-specific format to a standard format. The IoT data may be preprocessed through steps such as, but not limited to, data cleaning, data quality assessment, data transformation, data reduction etc.

At step 504, a digital twin of the at least one asset 108 in the IoT environment is configured based on the IoT data received. It must be understood by a person skilled in the art that historical data (e.g., operation data, performance data, maintenance data, etc.) of the asset 108 may be used along with the received IoT data to configure the digital twin. In the present invention, the digital twin is configured to generate a virtual representation indicative of a state of the asset 108 corresponding to a timestamp corresponding to the IoT data. The timestamp indicates an instance at which the IoT data was sensed or computed. Herein, configuring the digital twin may be used to refer to one of generating the digital twin for the first time, or updating an existing digital twin with real-time IoT data. In an embodiment, the digital twin management module 122 configures or generates the digital twin of the at least one asset 108 using similar digital twins available in the database 124 of the cloud computing system 102. In an alternate embodiment, the digital twin may be generated once during the lifecycle of the at least one asset 108 and updated in real-time based on the IoT data received from the at least one source.

In a further embodiment, the digital twin of the asset 108 may be further validated based on a set of validation rules. Upon successful validation, a unique signature may be generated for the digital twin. The unique signature may include validation timestamp, unique identifier of the digital twin and the unique identifier of the asset 108.

At step 506, a data package is generated, by the cloud computing system 102, based on the configured digital twin of at least one asset 108 by invoking a connector script. In an implementation, the data package is generated by firstly, determining a type of the event based on the IoT data. For example, the IoT data maybe indicative of temperature data. The corresponding event may be identified as an unusual variation of temperature beyond a predefined range. Selecting the digital twin data from data points associated with an instance or state of the digital twin in real-time. For example, the digital twin data may be indicative of a temperature distribution on a surface of the asset 108 computed based on the IoT data using predetermined correlations. The correlations may be computed using pretrained machine learning models that compute one or more operational attributes of the asset 108 based on a given set of IoT data. For example, if the asset 108 is an induction motor, the correlation may be associated with computing rotor temperature based on a stator temperature received from the source. Therefore, attributes of the motor that are independent of rotor temperature may be avoided for generating the data package.

Further, digital twin data to be provided to the client 114 is provisioned using the connector script. The connector script generates a custom connector and corresponding metadata based on a target schema corresponding to the client 114. The target schema is representative of a specific data structure or format for the data package, for the client 114 to successfully process the data package. The metadata defines information such as process forms, lookup definitions, scheduled tasks, and so on, for performing a connector operation between the cloud-based platform 102 and the client 114. Process forms convert specific data fields in the data package into an electronic format comprehensible by the client 114. Lookup definitions enable the client 114 to fetch values of specific data fields. The scheduled tasks may include, for example, regular syncing between the cloud-computing platform 102 and the client 114. Further, the data package is generated based on the provisioned digital twin data.

It may be understood that the digital twin data of the asset 108 may be provisioned for one or more clients of the cloud computing system 102. Consequently, the present invention enables transmitting data packages comprising different sets of digital twin data to multiple clients, in order to enable parallel analysis.

At step 508, the at least one data package is transmitted, by the cloud computing system 102, to the client 114. The closed loop simulation module 126 associated with the client 114 analyses the behavior of the asset 108 based on the data package algorithm to compute one or more optimized operational parameters for the asset 108, as explained earlier with reference to FIG 3.

In a further embodiment, the client 114 may further ingest one or more optimized operational parameters for the asset 108, to the cloud computing system 102, via the connector. The cloud computing system 102 may further provide the one or more operational parameters to a target device in the IoT environment. In an embodiment, the target device is configured to control an operation of the asset 108 based on the one or more optimized operational parameters. For example, the target device may be an edge device or an industrial control system that may modify operational parameters of the asset 108 to apply the optimized operational parameters. In another embodiment, the cloud computing platform 120 configures a user interface associated with the target device based on the one or more optimized operational parameters. For example, the target device may include a display that may show a notification indicating the optimized operational parameters to an operator. Further, the notification may also include a choice for the operator to 'accept' or 'decline' the optimized operational parameters. If the operator chooses to 'accept' the optimized operational parameters to apply the optimized operational parameters. Otherwise, the operator may choose to 'decline' or ignore the optimized operational parameters if the optimized operational parameters are not to be applied to the asset 108. The notification may be rendered using, for example, augmented reality, virtual reality, three-dimensional content or two-dimensional content.

Advantageously, the present invention enables seamless control of operation or auto-tuning of assets based on changes in operating conditions or operating environment of the assets using digital twins configured with the help of the cloud computing platform 120. In other words, a human operator need not manually tune operational parameters of the asset 108.

While the invention has been illustrated and described in detail with the help of a preferred embodiment, the invention is not limited to the disclosed examples. Other variations may be deducted by those skilled in the art without leaving the scope of protection of the claimed invention.

### List of reference numerals

- 100: system
- 102: cloud computing platform
- 104: network
- 106A-M: industrial plant
- 108A-N, 110A-N, 112A-N: assets
- 114: client
- 116: cloud interface
- 118: cloud hardware and Operating System (OS),
- 120: cloud computing platform
- 122: digital twin management module
- 124: database
- 126: closed loop simulation module
- 202: one or more processors
- 204: memory unit
- 206: storage unit
- 208: communication interface
- 210: cloud adapter
- 302: simulation model generation module
- 304: simulation instance creation module
- 306: simulation instance execution module
- 308: optimization module
- 310: notification module
- 402: IoT data processing module
- 404: digital twin configuration module
- 406: data packaging module
- 408: control module
- 410: visualization module

## Claims

1. A method (500) comprising:
receiving, by a cloud computing system (102), IoT data indicative of an event in an IoT environment, from a source;
configuring a digital twin, of at least one asset (108) in the IoT environment, based on the received IoT data;
generating a data package based on the configured digital twin of the asset (108) by invoking a connector script; and
transmitting the generated data package to the client (114), wherein the client (114) analyses a behavior of the asset (108) based on the data package to compute one or more optimized operational parameters for the asset (108).

2. The method according to claim 1, wherein the event is a change in at least one of an operating condition of the asset (108) and an operating environment of the asset (108), detected by the source in real-time.

3. The method according to any of the claims 1 to 2, wherein generating the data package based on the configured digital twin of the asset (108) by invoking the connector script comprises:
provisioning digital twin data to be provided to the client (114) using the connector script; and
generating the data package based on the provisioned digital twin data.

4. The method according to any of the claims 1 to 3, wherein analyzing the behavior of the asset (108) based on the data package, by the client (114), comprises:
configuring an asset simulation model for the asset (108), based on the data package;
generating one or more asset simulation instances based on the configured asset simulation model;
executing the one or more asset simulation instances in a simulation environment, to generate one or more simulated responses; and
using an optimization algorithm to compute one or more optimized operational parameters for the asset (108) based on analysis of the one or more simulated responses.

5. The method according to any of the claims 1 to 4, further comprising:
obtaining the one or more optimized operational parameters from the client (114); and
providing the optimized operational parameters to a target device in the IoT environment.

6. The method according to claim 5, wherein the target device is configured to control an operation of the asset (108) based on the one or more optimized operational parameters.

7. The method according to claim 5 or 6, further comprising:
configuring a user interface associated with the target device based on the one or more optimized operational parameters.

8. A system (100) comprising:
at least one source configured to provide Internet-of-Things (IoT) data indicative of an event in an IoT environment;
at least one client (114); and
a cloud computing system (102) communicatively coupled to the at least one source and the at least one client (114), wherein the cloud computing system (102) is configured for:
receiving the IoT data indicative of the event in the IoT environment from the source;
configuring a digital twin, of at least one asset in the IoT environment, based on the received IoT data;
generating a data package based on the configured digital twin of the asset (108) by invoking a connector script; and
transmitting the generated data package to the client (114), wherein the client (114) is configured to analyze a behavior of the asset (108) based on the data package, to compute one or more optimized operational parameters for the asset (108).

9. The system (100) according to claim 8, wherein the source is associated with at least one of a sensor, an actuator, an industrial control system and an edge device within the IoT environment.

10. A cloud computing system (102) configured for:
receiving IoT data indicative of an event in an IoT environment from a source;
configuring a digital twin, of at least one asset (108) in the IoT environment, based on the received IoT data;
generating a data package based on the configured digital twin of the asset (108) by invoking a connector script; and
transmitting the generated data package to a client (114), wherein the client (114) analyzes a behavior of the asset (108) based on the data package, to compute one or more optimized operational parameters for the asset (108).

11. A computer program product, comprising computer program code which, when executed by a cloud computing system (102), cause the cloud computing system (102) to carry out the method of one of the claims 1 to 7.

12. A computer-readable medium comprising a computer program product comprising computer program code which, when executed by a cloud computing system (102), cause the the cloud computing system (102) to carry out the method of one of the claims 1 to 7.
